# EUROPEAN PATENT APPLICATION

(11) **EP 1 403 925 A2**
(43) Date of publication of application: **31.03.2004**
(21) Application number: 03255987.4
(22) Date of filing: 23.09.2003
(51) Int. Cl.: H01L 23/532, H01L 21/768

(54) **Dielectric material for electronic devices**

(30) Priority: 24.09.2002 US 413265 P
(71) Applicant: Shipley Co. L.L.C., Marlborough, MA 01752 (US)
(72) Inventor: Gronbeck, Dana A., Holliston, Massachusetts 01746 (US); Gallagher, Michael K., Hopkinton, Massachusetts 01748 (US); Calvert, Jeffrey M., Acton, Massachusetts 01720 (US); Adams, Timothy G., Sudbury, Massachusetts 01776 (US)
(74) Representative: Kent, Venetia Katherine

(57) **Abstract**

A method for manufacturing electronic devices using multiple layers of pre-porous dielectric materials that are made porous subsequent to etching and metal filling of apertures is provided. The pre-porous layers may be made porous sequentially or during a single processing step. Such pre-porous dielectric layers are selected not only to provide low dielectric constants after being made porous, but also to provide a difference in etch rates. Structures having such multiple layers of pre-porous dielectric layers are also provided.

## Description

### Background of the Invention

This invention relates generally to the field of manufacture of electronic devices. In particular, this invention relates to the manufacture of integrated circuit devices containing low dielectric constant material.

As electronic devices become smaller, there is a continuing desire in the electronics industry to increase the circuit density in electronic components, e.g., integrated circuits, circuit boards, multichip modules, chip test devices, and the like without degrading electrical performance, e.g., crosstalk or capacitive coupling, and also to increase the speed of signal propagation in these components. One method of accomplishing these goals is to reduce the dielectric constant of the interlayer, or intermetal, insulating material used in the components.

A variety of organic and inorganic porous dielectric materials are known in the art in the manufacture of electronic devices, particularly integrated circuits. Suitable inorganic dielectric materials include silicon dioxide and organic polysilicas. Suitable organic dielectric materials include thermosets such as polyimides, polyarylene ethers, polyarylenes, polycyanurates, polybenzazoles, benzocyclobutenes, fluorinated materials such as poly(fluoroalkanes), and the like. Of the organic polysilica dielectrics, the alkyl silsesquioxanes such as methyl silsesquioxane are of increasing importance because of their low dielectric constant.

A method for reducing the dielectric constant of interlayer, or intermetal, insulating material is to incorporate within the insulating film very small, uniformly dispersed pores or voids. In general, such porous dielectric materials may be prepared by first incorporating a removable porogen into a B-staged dielectric material, disposing the B-staged dielectric material containing the removable porogen onto a substrate, curing the B-staged dielectric material and then removing the porogen to form a porous dielectric material. For example, U.S. Patent Nos. 6,271,273 (You et al.) and 6,420,441 (Allen et al.) disclose processes for forming integrated circuits containing porous dielectric materials. Other methods of forming porous dielectric materials are known, such as grafting a removable polymer into the vitrifying dielectric matrix followed by removal of the polymer after the matrix has cured.

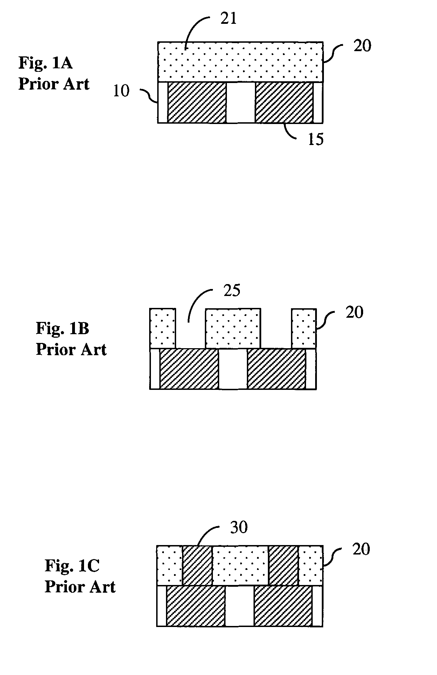

After the porous dielectric material is formed, it is subjected to conventional processing conditions of patterning, etching apertures, optionally applying a barrier layer and/or seed layer, metallizing or filling the apertures, planarizing the metallized layer, and then applying a cap layer or etch stop. In a multilayer stack, such process is repeated until the desired levels of the device are obtained. When removable material is used to form the porous dielectric layer, such conventional process requires that the removable material be removed after each dielectric layer is applied. Figs. 1A-1C illustrate a prior art method of manufacturing an integrated circuit using a conventionally prepared dielectric material 20 having pores or voids 21 disposed on a substrate 10 having metal studs 15. In a typical process, an antireflective coating is optionally applied to the surface of the porous dielectric layer. A photoresist is then applied to the surface of the antireflective coating or porous dielectric layer and the photoresist is exposed to pattern the dielectric porous layer. After patterning, the porous dielectric layer is etched to provide apertures and the photoresist is then removed. Fig. 1B illustrates a conventionally prepared porous dielectric material 20 following etching to form apertures 25 and removal of the photoresist. Fig. 1C illustrates another step of such conventional processes in which a metal 30, such as copper, fills the apertures in the dielectric material 20.

One problem with such porous materials in certain circumstances is that apertures etched into such porous dielectric materials suffer from sidewall roughness due to the pores in the dielectric material. Such sidewall roughness creates difficulties in the subsequent deposition of metal layers such as barrier or seed layers. The barrier or seed layers are typically chemically or physically vapor deposited in a line of sight fashion. Roughness in the aperture sidewalls tends to create discontinuities in the barrier and/or seed layers. These discontinuities can adversely affect subsequent processing steps in the manufacture of and the performance of electronic devices. U.S. Patent No. 6,596,467 (Gallagher et al.) provides a solution to this problem by removing any porogen from the dielectric material after metal deposition and subsequent planarization. However, this approach does not address other problems arising during the manufacture of integrated circuits.

A disadvantage of certain porous dielectric materials, including porous organic polysilica dielectric materials, is that they may not provide sufficient resistance to planarization techniques, such as chemical mechanical planarization ("CMP") used in subsequent manufacturing steps or sufficient resistance to etching, such as oxygen plasma, during photoresist removal from such dielectric materials. One solution to this is to use a layer of a different material atop the dielectric material (i.e., a cap layer) to provide the desired characteristics. Cap layers are useful in both single and dual damascene processes, particularly when porous dielectric materials are used. These layers planarize the surface of the dielectric by filling any surface defects, provide a denser matrix than that of the dielectric so as to seal any porosity having connectivity to the surface of the dielectric film (prevents intrusion of any residues from subsequent processing into the porous dielectric), improve the adhesion with subsequently applied layers of material and provide a hardmask having sufficient resistance to subsequent processing steps and etch differential between it and the underlying porous dielectric layer to allow sequential selective pattern transfers between successive layers of photoimaged pattern, cap layer and dielectric. Suitable cap layer compositions must be able to provide good coating uniformity in the required thickness range (e.g., 100 to 600 Å) and have a low dielectric constant (k ≤ 3.5).

Although certain organic cap layers have recently been recommended, such as poly(arylene ethers), typical cap layers are based on silicon dioxide, silicon carbide, silicon nitride, silicon oxynitride and the like. Conventionally, organic-inorganic or inorganic-organic layers are used to provide etch selectivity. For example, an organic cap layer is used atop an inorganic dielectric layer and, likewise, an inorganic cap layer is used atop an organic dielectric material. In particular, a conventional poly(arylene ether) dielectric material may have a non-porous methyl silsesquioxane capping layer, or alternatively, a conventional methyl silsesquioxane dielectric layer may have a non-porous poly(arylene ether) capping layer. Such alternating organic-inorganic layered structures suffer from coefficient of thermal expansion ("CTE") mismatch, which makes failures in such structures possible.

It is desired to have a cap layer that has a CTE that is substantially matched to the CTE of the dielectric material used. It is also desired to have a cap layer that has a lower dielectric constant than conventional cap layers in order to keep the overall dielectric constant of the stack as low as possible.

### Summary of the Invention

One way to achieve substantially matched coefficients of thermal expansion of a dielectric layer and a cap layer is to use the same compositions for both layers. However, the use of the same composition for both layers does not provide sufficient etch differential between the layers. Applicants have found that similar matrix compositions can be used for both a dielectric layer and an etch differentiating layer, such as a cap layer, hardmask, etch stop and the like. Suitable etch differential between such layers can be achieved through the use of certain removable material in the dielectric material composition, the etch differentiating material composition or both.

The present invention provides a structure including a first dielectric layer including a first porogen, and a second dielectric layer including a second porogen. Also provided is a structure including a first layer of a dielectric material including a porogen, a second layer including a sacrificial material, and a third layer on the second layer, wherein the third layer is inorganic.

Further, the present invention provides a method of manufacturing an electronic device including the steps of: a) disposing on a substrate a layer of a first dielectric material including a first porogen; b) disposing a layer of a second dielectric material on the first dielectric material layer, wherein the second dielectric material includes a second porogen. A method of manufacturing an electronic device including the steps of: a) disposing on a substrate a first layer of a dielectric material including a porogen; b) disposing on the first layer a second layer including a sacrificial material; c) disposing a third layer on the second layer, wherein the third layer is inorganic is also provided.

The present invention still further provides a method of manufacturing an electronic device including the steps of: a) disposing on a substrate a layer of a first dielectric material including a first porogen; b) disposing a layer of a second dielectric material on the first dielectric material layer, the second dielectric material including a second porogen or a sacrificial material; c) patterning the layers of both the first and second dielectric materials to provide apertures; d) vapor depositing a barrier layer on the surface of the first and second dielectric materials within the apertures; and e) depositing a metal into the apertures; wherein the first porogen, the second porogen and the sacrificial material have active sites suitable for providing a barrier layer.

Also disclosed herein is a method of manufacturing an electronic device including the steps of: a) disposing on a substrate a layer of a dielectric material; b) patterning the dielectric material layer to provide apertures; c) depositing a barrier layer in the apertures; d) depositing copper in the apertures to fill the apertures; e) planarizing the copper; and f) selectively depositing a barrier layer on the surface of the copper. This invention also provides a method of selectively providing a barrier layer on a copper surface in the manufacture of an integrated circuit.

Additionally, the invention provides a structure including a substrate; a dielectric layer disposed on the surface of the substrate, the dielectric layer comprising apertures extending from a top surface of the dielectric layer downardly into the dielectric layer; copper disposed in the apertures and having a top surface substantially even with the top surface of the dielectric layer; and a barrier layer selectively disposed on the top surface of the copper.

### Brief Description of the Drawing

Figs. 1A-1C show cross-sections of a portion of an integrated circuit device, not to scale, illustrating a prior art approach to the use of a porous dielectric layer.
Figs. 2A-2J show cross-sections of a portion of an integrated circuit device, not to scale, illustrating several steps in the method of the invention.
Figs. 3A-3C show cross-sections of alternate embodiments of the invention, not to scale.
Figs. 4A-4C show cross-sections of alternate embodiments of the invention, not to scale.
Fig. 5 shows a cross-section of a portion of an integrated circuit device, not to scale, illustrating an alternate embodiment of the invention.

### Detailed Description of the Invention

As used throughout this specification, the following abbreviations shall have the following meanings, unless the context clearly indicates otherwise: ° C = degrees centigrade; UV = ultraviolet; nm = nanometer; g = gram; wt% = weight percent; L = liter; µm = micron = micrometer; rpm = revolutions per minute; N = normal; ca. = approximately; DI = deionized; and ppm = parts per million.

The term "(meth)acrylic" includes both acrylic and methacrylic and the term "(meth)acrylate" includes both acrylate and methacrylate. Likewise, the term "(meth)acrylamide" refers to both acrylamide and methacrylamide. The term "alkyl" includes straight chain, branched and cyclic alkyl groups. As used throughout the specification, "feature" refers to the geometries on a substrate. "Apertures" refer to recessed features, such as vias and trenches.

The term "porogen" refers to a pore forming material, that is a material such as polymeric particles dispersed in a dielectric material that is subsequently removed to yield pores, voids or free volume in the dielectric material. The terms "pore" and "void" are used interchangeably throughout this specification. The term "removable material" used in this specification refers to any material that is removed from a dielectric layer, including porogens and sacrificial material, to form a porous dielectric layer. "Sacrificial material" refers to any material that forms a layer of material on a substrate that is later removed to leave an air gap.

"Cross-linker" and "cross-linking agent" are used interchangeably throughout this specification. "Polymer" refers to polymers and oligomers, and also includes homopolymers and copolymers. The terms "oligomer" and "oligomeric" refer to dimers, trimers, tetramers and the like. "Monomer" refers to any ethylenically or acetylenically unsaturated compound capable of being polymerized or other compound capable of being polymerized by condensation. Such monomers may contain one or more double or triple bonds or groups capable of being polymerized by condensation.

The term "B-staged" refers to uncured dielectric materials. By "uncured" is meant any material that can be polymerized or cured to form higher molecular weight materials, such as coatings or films. As used herein, "partially cured" refers to a film or coating of dielectric material that has been sufficiently cured so that only 1% or less of the thickness of the film is lost upon contact with a solvent suitable for dissolving the B-staged organic polysilica resin. Such partially cured films or coatings may undergo further curing during subsequent processing steps. "Films" and "Layers" are used interchangeably throughout this Specification. B-staged materials may be monomeric, oligomeric or mixtures thereof. B-staged material is further intended to include mixtures of polymeric material with monomers, oligomers or a mixture of monomers and oligomers.

Unless otherwise noted, all amounts are percent by weight and all ratios are by weight. All numerical ranges are inclusive and combinable in any order, except where it is clear that such numerical ranges are constrained to add up to 100%.

The present invention provides a method of forming a multilayer dielectric stack having more than one porous layer wherein the porous layers are formed after the dielectric stack is built. Applicants have found that a first pre-porous dielectric layer may be applied to a substrate and a second pre-porous dielectric layer applied to the surface of the first pre-porous dielectric layer. Subsequent pre-porous dielectric layers may be added as desired. "Pre-porous dielectric" material or layer refers to a dielectric material including a removable material, such as a porogen, that is removed under certain conditions to provide a porous dielectric layer having a reduced dielectric constant as compared to the corresponding non-porous dielectric layer. The dielectric layers may be of any suitable thickness. Such thicknesses will depend upon the insulating properties desired, the particular dielectric material selected, and the design of the device being built, among other considerations. Typically, such pre-porous dielectric compositions contain removable material. Accordingly, the present invention provides a structure including a first dielectric layer including a first removable material, and a second dielectric layer including a second removable material. Particularly useful removable materials are porogens. In one embodiment, both the first and second dielectric layers are inorganic.

After such stack of pre-porous dielectric layers is built, porous dielectric layers are formed from the pre-porous dielectric layers. To make such a structure having a porous dielectric stack, the structure is subjected to conditions which at least partially remove the removable material from each of the dielectric layers. Typically, the removable material is removed after any etching step. In another embodiment, the removable material is removed subsequent to any aperture filling metallization and planarization steps.

Preferably, the removable material is first at least partially removed from the topmost dielectric layer, followed by at least partially removing the removable material from the next layer and so on down the stack. It will be appreciated that the removable material does not need to be completely removed from an overlying dielectric layer before the removable material in the next lower dielectric layer begins to be removed. Under certain conditions, the removable material from adjacent layers may be removed concurrently.

The removable material in a first dielectric layer and the removable material in a second dielectric layer may be same or different. By employing different removable materials, a removable material used in the topmost dielectric layer may be selected such that it is removed under milder conditions than a removable material used in the next lower dielectric layer. Differences in conditions used to remove the removable materials can be achieved by using removable materials having different compositions. For example, a first porogen in a topmost dielectric layer may be used as it is removed at a lower temperature than a second porogen in the next lower dielectric layer, and so on. Such selectivity in porogen removal can be achieved by a variety of ways, such as by varying polymer compositions, varying the amount of cross-linking by choice of removal conditions and combinations thereof. For example, certain porogens will be removed at one temperature when heated in air and at a different temperature when heated in an inert atmosphere such as nitrogen. In one embodiment, a top dielectric layer may contain a porogen that is removed at a temperature and the next lower dielectric layer may contain a porogen that is stable at that temperature when exposed in one atmosphere, but is removed at that temperature when the atmosphere is changed. In this example, the structure is heated at a temperature in a first atmosphere to at least partially remove the porogen from the top dielectric layer and then the atmosphere is changed to at least partially remove the porogen from the next dielectric layer.

In one embodiment, an etch differentiating layer is optionally disposed between the first dielectric layer and the second dielectric layer. As used herein, the term "etch differentiating layer" or "etch differentiating material" refers to a layer of material that is used on a dielectric layer, under a dielectric layer or between dielectric layers to provide an etch differential as compared to the dielectric layer. Suitable etch differentiating layers include, without limitation, cap layers, etch stops, hardmasks and the like. As etch differentiating layers are used predominately to provide an etch differential as compared to the dielectric layer, they are typically thinner than dielectric layers, but may be used in a wide range to thicknesses. Typically, such etch differentiating layers have a thickness of ≤ 100 nm, and preferably in the range of 50 to 100 nm, however, thicker films may be used advantageously. Such etch differentiating layers also function as insulating layers.

When an etch differentiating layer is used as an etch stop between a first pre-porous dielectric layer and a second dielectric layer, or as a cap layer or hardmask over a pre-porous dielectric layer, the etch differentiating layer must have sufficient porosity to allow for removal of the removable material from the underlying pre-porous dielectric layer through the etch differentiating layer. Suitable etch differentiating layers having sufficient porosity are aerogels and xerogels. In an alternate embodiment, a porous etch differentiating layer including a removable material, preferably a porogen, is used. One of the advantages of the present invention is that the overall dielectric constant of the stack is reduced as compare to conventional dielectric stacks. Such porous etch differentiating layers help to reduce the overall dielectric constant of the stack as compared to conventional etch differentiating layers.

When no etch differentiating layer is used between two dielectric layers, the dielectric layers are typically chosen such that there is an etch differential between the dielectric layers of at least 1:2. As used herein, "etch differential" refers to a ratio of etch rates of two materials. There is no upper limit to the etch differential that may be used. When an etch differentiating layer is used, the etch differential between such etch differentiating layer and a dielectric layer disposed on or under such etch differentiating layer is also at least 1:2. A typical range of etch differentials is from 1:2 to 1:65 and preferably from 1:2 to 1:20, although other etch differentials may be suitable.

Such desired etch differential can be achieved in one embodiment by using different compositions for the different layers. For example, etch differential is achieved in conventional processes using an organic dielectric layer with an inorganic etch differentiating layer, or alternatively, using an inorganic dielectric layer and an organic etch differentiating layer. When such etch differentiating layer is to remain in the device, such as when it is a buried etch stop layer, CTE mismatch is a concern. This CTE mismatch can be overcome by using an inorganic dielectric with an inorganic etch differentiating layer. Preferably, the dielectric layer and the etch differentiating layer both have essentially the same composition, e.g. both layers are organic or inorganic. In particular, both the dielectric layer and the etch differentiating layer are organic polysilica layers.

When the dielectric layers, and optional etch differentiating layers, are all inorganic, the desired etch selectivity can be achieved by the use of certain removable materials. Higher etch resistance can be achieved in a dielectric or etch differentiating layer by increasing the carbon content in that layer. Such carbon content can be increased in a layer by using a removable material having a higher carbon content or by using a dielectric composition that has a higher carbon content or by using both methods. Removable materials having a high carbon content are preferably those having a high aromatic carbon content. As an example, a (meth)acrylate-based polymeric porogen in a first dielectric layer would provide very different etch resistance as compared to a polymeric porogen having a high aromatic content, such as a styrene or divinyl benzene-based polymeric porogen, used in an etch differentiating layer. Carbon content in an organic polysilica layer can be increased by modifications to the organic group, e.g. changing the organic group from an alkyl group to an aromatic group. For example, a dielectric layer including an alkyl silsesquioxane may be used with an etch differentiating layer including an aromatic silsesquioxane.

Any B-staged dielectric material capable of forming porous dielectric material may be used in the present invention. Suitable B-staged dielectric materials include, but are not limited to inorganic materials such as organic polysilicas, carbides, oxides, nitrides and oxyfluorides of silicon, boron, or aluminum; and organic matrix materials such as benzocyclobutenes, poly(aryl esters), poly(ether ketones), polycarbonates, poly(arylene ethers), polyaromatic hydrocarbons, such as polynaphthalene, polyquinoxalines, poly(perfluorinated hydrocarbons) such as poly(tetrafluoroethylene), polyimides, polybenzoxazoles and polycycloolefins such as polynorbornenes. Such B-staged dielectric materials are generally commercially available or may be prepared by methods known in the literature.

By "organic polysilica resin" (or organo siloxane) is meant a compound including silicon, carbon, oxygen and hydrogen atoms. Suitable organic polysilica resins are hydrolyzates or partial condensates of one or more silanes of formulae (I) or (II):

RₐSiY₄₋ₐ (I)

R¹ _{b}(R²O)_{3-b}Si(R³)_{c}Si(OR⁴)_{3-d}R⁵ _{d} (II)

wherein R is hydrogen, (C₁-C₈)alkyl, (C₇-C₁₂)arylalkyl, substituted (C₇-C₁₂)arylalkyl, aryl, and substituted aryl; Y is any hydrolyzable group; a is an integer of 0 to 2; R¹, R², R⁴ and R⁵ are independently selected from hydrogen, (C₁-C₆)alkyl, (C₇-C₁₂)arylalkyl, substituted (C₇-C₁₂)arylalkyl, aryl, and substituted aryl; R³ is selected from (C₁-C₁₀)alkyl, -(CH₂)ₕ-, -(CH₂)ₕ₁-Eₖ-(CH₂)ₕ₂-, -(CH₂)ₕ-Z, arylene, substituted arylene, and arylene ether; E is selected from oxygen, NR⁶ and Z; Z is selected from aryl and substituted aryl; R⁶ is selected from hydrogen, (C₁-C₆)alkyl, aryl and substituted aryl; b and d are each an integer of 0 to 2; c is an integer of 0 to 6; and h, h1, h2 and k are independently an integer from 1 to 6; provided that at least one of R, R¹, R³ and R⁵ is not hydrogen. "Substituted arylalkyl", "substituted aryl" and "substituted arylene" refer to an arylalkyl, aryl or arylene group having one or more of its hydrogens replaced by another substituent group, such as cyano, hydroxy, mercapto, halo, (C₁-C₆)alkyl, (C₁-C₆)alkoxy, and the like.

It is preferred that R is (C₁-C₄)alkyl, benzyl, hydroxybenzyl, phenethyl or phenyl, and more preferably methyl, ethyl, iso-butyl, tert-butyl or phenyl. Preferably, a is 1. Suitable hydrolyzable groups for Y include, but are not limited to, halo, (C₁-C₆)alkoxy, acyloxy and the like. Preferred hydrolyzable groups are chloro and (C₁-C₂)alkoxy. Suitable organosilanes of formula (I) include, but are not limited to, methyl trimethoxysilane, methyl triethoxysilane, phenyl trimethoxysilane, phenyl triethoxysilane, tolyl trimethoxysilane, tolyl triethoxysilane, propyl tripropoxysilane, iso-propyl triethoxysilane, iso-propyl tripropoxysilane, ethyl trimethoxysilane, ethyl triethoxysilane, iso-butyl triethoxysilane, iso-butyl trimethoxysilane, tert-butyl triethoxysilane, tert-butyl trimethoxysilane, cyclohexyl trimethoxysilane, cyclohexyl triethoxysilane, benzyl trimethoxysilane, benzyl triethoxysilane, phenethyl trimethoxysilane, hydroxybenzyl trimethoxysilane, hydroxyphenylethyl trimethoxysilane and hydroxyphenylethyl triethoxysilane.

Organosilanes of formula (II) preferably include those wherein R¹ and R⁵ are independently (C₁-C₄)alkyl, benzyl, hydroxybenzyl, phenethyl or phenyl. Preferably R¹ and R⁵ are methyl, ethyl, tert-butyl, iso-butyl and phenyl. It is also preferred that b and d are independently 1 or 2. Preferably R³ is (C₁-C₁₀)alkyl, -(CH₂)ₕ-, arylene, arylene ether and - (CH₂)ₕ₁-E-(CH₂)ₕ₂. Suitable compounds of formula (II) include, but are not limited to, those wherein R³ is methylene, ethylene, propylene, butylene, hexylene, norbornylene, cycloheylene, phenylene, phenylene ether, naphthylene and -CH₂-C₆H₄-CH₂-. It is further preferred that c is 1 to 4.

Suitable organosilanes of formula (II) include, but are not limited to, bis(hexamethoxysilyl)methane, bis(hexaethoxysilyl)methane, bis(hexaphenoxysilyl)methane, bis(dimethoxymethylsilyl)methane, bis(diethoxymethyl-silyl)methane, bis(dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane, bis(ethoxydiphenylsilyl)methane, bis(hexamethoxysilyl)ethane, bis(hexaethoxysilyl)ethane, bis(hexaphenoxysilyl)ethane, bis(dimethoxymethylsilyl) ethane, bis(diethoxymethylsilyl)ethane, bis(dimethoxyphenylsilyl)ethane, bis(diethoxyphenylsilyl)ethane, bis(methoxydimethylsilyl)ethane, bis(ethoxydimethylsilyl)ethane, bis(methoxydiphenylsilyl)ethane, bis(ethoxydiphenylsilyl)ethane, 1,3-bis(hexamethoxysilyl))propane, 1,3-bis(hexaethoxysilyl)propane, 1,3-bis(hexaphenoxysilyl)propane, 1,3-bis(dimethoxymethylsilyl)propane, 1,3-bis(diethoxymethylsilyl)propane, 1,3-bis(dimethoxyphenylsilyl)propane, 1,3-bis(diethoxyphenylsilyl)propane, 1,3-bis(methoxydimehylsilyl)propane, 1,3-bis(ethoxydimethylsilyl)propane, 1,3-bis(methoxydiphenylsilyl)propane, and 1,3-bis(ethoxydiphenylsilyl)propane. Preferred of these are hexamethoxydisilane, hexaethoxydisilane, hexaphenoxydisilane, 1,1,2,2-tetramethoxy-1,2-dimethyldisilane, 1,1,2,2-tetraethoxy-1,2-dimethyldisilane, 1,1,2,2-tetramethoxy-1,2-diphenyldisilane, 1,1,2,2-tetraethoxy-1,2-diphenyldisilane, 1,2-dimethoxy-1,1,2,2-tetramethyldisilane, 1,2-diethoxy-1,1,2,2-tetramethyldisilane, 1,2-dimethoxy-1,1,2,2-tetraphenyldisilane, 1,2-diethoxy-1,1,2,2-tetraphenyldisilane, bis(hexamethoxysilyl)methane, bis(hexaethoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane, and bis(ethoxydiphenylsilyl)methane.

When the B-staged organic polysilica resins comprise a hydrolyzate or partial condensate of organosilanes of formula (II), c may be 0, provided that at least one of R¹ and R⁵ are not hydrogen. In an alternate embodiment, the B-staged organic polysilica resins may comprise a cohydrolyzate or partial cocondensate of organosilanes of both formulae (I) and (II). In such cohydrolyzates or partial cocondensates, c in formula (II) can be 0, provided that at least one of R, R¹ and R⁵ is not hydrogen. Suitable silanes of formula (II) where c is 0 include, but are not limited to, hexamethoxydisilane, hexaethoxydisilane, hexaphenoxydisilane, 1,1,1,2,2-pentamethoxy-2-methyldisilane, 1,1,1,2,2-pentaethoxy-2-methyldisilane, 1,1,1,2,2-pentamethoxy-2-phenyldisilane, 1,1,1,2,2-pentaethoxy-2-phenyldisilane, 1,1,2,2-tetramethoxy-1,2-dimethyldisilane, 1,1,2,2-tetraethoxy-1,2-dimethyldisilane, 1,1,2,2-tetramethoxy-1,2-diphenyldisilane, 1,1,2,2-tetraethoxy-1,2-diphenyldisilane, 1,1,2-trimethoxy-1,2,2-trimethyldisilane, 1,1,2-triethoxy-1,2,2-trimethyldisilane, 1,1,2-trimethoxy-1,2,2-triphenyldisilane, 1,1,2-triethoxy-1,2,2-triphenyldisilane, 1,2-dimethoxy-1,1,2,2-tetramethyldisilane, 1,2-diethoxy-1,1,2,2-tetramethyldisilane, 1,2-dimethoxy-1,1,2,2-tetraphenyldisilane, and 1,2-diethoxy-1,1,2,2-tetra-phenyldisilane.

In one embodiment, particularly suitable B-staged organic polysilica resins are hydrolyzates or partial condensates of compounds of formula (I). Such B-staged organic polysilica resins have the formula (III):

((R⁷R⁸SiO)ₑ(R⁹SiO_{1.5})_{f}(R¹⁰SiO_{1.5})_{g}(SiO₂)ᵣ)ₙ (III)

wherein R⁷, R⁸, R⁹ and R¹⁰ are independently selected from hydrogen, (C₁-C₆)alkyl, (C₇-C₁₂)arylalkyl, substituted (C₇-C₁₂)arylalkyl, aryl, and substituted aryl; e, g and r are independently a number from 0 to 1; f is a number from 0.2 to 1; n is integer from 3 to 10,000; provided that e + f + g + r = 1; and provided that at least one of R⁷, R⁸ and R⁹ is not hydrogen. In the above formula (III), e, f, g and r represent the mole ratios of each component. Such mole ratios can be varied between 0 and 1. It is preferred that e is from 0 to 0.8. It is also preferred that g is from 0 to 0.8. It is further preferred that r is from 0 to 0.8. In the above formula, n refers to the number of repeat units in the B-staged material. Preferably, n is an integer from 3 to 1000.

Suitable organic polysilica resins include, but are not limited to, silsesquioxanes, partially condensed halosilanes or alkoxysilanes such as partially condensed by controlled hydrolysis tetraethoxysilane having number average molecular weight of 500 to 20,000, organically modified silicates having the composition RSiO₃, O₃SiRSiO₃, R₂SiO₂ and O₂SiR₃SiO₂ wherein R is an organic substituent, and partially condensed orthosilicates having Si(OR)₄ as the monomer unit. Silsesquioxanes are polymeric silicate materials of the type RSiO_{1.5} where R is an organic substituent. Suitable silsesquioxanes are alkyl silsesquioxanes such as methyl silsesquioxane, ethyl silsesquioxane, propyl silsesquioxane, butyl silsesquioxane and the like; aryl silsesquioxanes such as phenyl silsesquioxane and tolyl silsesquioxane; alkyl/aryl silsesquioxane mixtures such as a mixture of methyl silsesquioxane and phenyl silsesquioxane; and mixtures of alkyl silsesquioxanes such as methyl silsesquioxane and ethyl silsesquioxane. B-staged silsesquioxane materials include homopolymers of silsesquioxanes, copolymers of silsesquioxanes or mixtures thereof. Such materials are generally commercially available or may be prepared by known methods.

In an alternate embodiment, the organic polysilica resins may contain a wide variety of other monomers in addition to the silicon-containing monomers described above. For example, the organic polysilica resins may further comprise cross-linking agents, and carbosilane moieties. Such cross-linking agents may be any of the cross-linking agents described elsewhere in this specification, or any other known cross-linkers for silicon-containing materials. It will be appreciated by those skilled in the art that a combination of cross-linkers may be used. Carbosilane moieties refer to moieties having a (Si-C)ₓ structure, such as (Si-A)ₓ structures wherein A is a substituted or unsubstituted alkylene or arylene, such as SiR₃CH₂-, -SiR₂CH₂-, =SiRCH₂-, and ≡SiCH₂-, where R is usually hydrogen but may be any organic or inorganic radical. Suitable inorganic radicals include organosilicon, siloxyl, or silanyl moieties. These carbosilane moieties are typically connected "head-to-tail", i.e. having Si-C-Si bonds, in such a manner that a complex, branched structure results. Particularly useful carbosilane moieties are those having the repeat units (SiHₓCH₂) and (SiH_{y-1}(CH=CH₂)CH₂), where x = 0 to 3 and y = 1 to 3. These repeat units may be present in the organic polysilica resins in any number from 1 to 100,000, and preferably from 1 to 10,000. Suitable carbosilane precursors are those disclosed in U.S. Patent Nos. 5,153,295 (Whitmarsh et al.) and 6,395,649 (Wu).

In one embodiment, the B-staged organic polysilica resin comprises a silsesquioxane, and more preferably methyl silsesquioxane, ethyl silsesquioxane, propyl silsesquioxane, iso-butyl silsesquioxane, tert-butyl silsesquioxane, phenyl silsesquioxane, tolyl silsesquioxane, benzyl silsesquioxane or mixtures thereof. Methyl silsesquioxane, phenyl silsesquioxane and mixtures thereof are particularly suitable. Other useful silsesquioxane mixtures include mixtures of hydrido silsesquioxanes with alkyl, aryl or alkyl/aryl silsesquioxanes. Typically, the silsesquioxanes useful in the present invention are used as oligomeric materials, generally having from 3 to 10,000 repeating units.

Other suitable organic polysilica B-staged resins are co-hydrolyzates or partial condensates of one or more organosilanes of formulae (I) and/or (II) and one or more tetrafunctional silanes having the formula SiY₄, where Y is any hydrolyzable group as defined above. Suitable hydrolyzable groups include, but are not limited to, halo, (C₁-C₆)alkoxy, acyloxy and the like. Preferred hydrolyzable groups are chloro and (C₁-C₂)alkoxy. Suitable tetrafunctional silanes of the formula SiY₄ include, but are not limited to, tetramethoxysilane, tetraethoxysilane, tetrachlorosilane, and the like. Particularly suitable silane mixtures for preparing the cohydrolyzates or partial cocondensates include: methyl triethoxysilane and tetraethoxysilane; methyl trimethoxysilane and tetramethoxysilane; phenyl triethoxysilane and tetraethoxysilane; methyl triethoxysilane and phenyl triethoxysilane and tetraethoxysilane; ethyl triethoxysilane and tetramethoxysilane; and ethyl triethoxysilane and tetraethoxysilane. The ratio of such organosilanes to tetrafunctional silanes is typically from 99:1 to 1:99, preferably from 95:5 to 5:95, more preferably from 90: 10 to 10:90, and still more preferably from 80:20 to 20:80.

In a particular embodiment, the B-staged organic polysilica resin is a co-hydrolyzate or partial co-condensate of one or more organosilanes of formula (I) and a tetrafunctional silane of formula SiY₄. In another embodiment, the B-staged organic polysilica resin is a co-hydrolyzate or partial co-condensate of one or more organosilanes of formula (II) and a tetrafunctional silane of formula SiY₄. In still another embodiment, the B-staged organic polysilica resin is a cohydrolyzate or partial co-condensate of one or more organosilanes of formula (I), one or more silanes of formula (II) and a tetrafunctional silane of formula SiY₄. The B-staged organic polysilica resins of the present invention include a non-hydrolyzed or non-condensed silane of one or more silanes of formulae (I) or (II) with the hydrolyzate or partial condensate of one or more silanes of formulae (I) or (II). In a further embodiment, the B-staged organic polysilica resin comprises a silane of formula (II) and a hydrolyzate of partial condensate of one or more organosilanes of formula (I), and preferably a co-hydrolyzate or partial co-condensate of one or more organosilanes of formula (I) with a tetrafunctional silane of the formula SiY₄ where Y is as defined above. Perferably, such B-staged organic polysilica resin comprises a mixture of one or more silanes of formula (II) and a co-hydrolyzate or partial co-condensate having the formula (RSiO_{1.5}) (SiO₂) where R is as defined above.

When organosilanes of formula (I) are co-hydrolyzed or co-condensed with a tetrafunctional silane, it is preferred that the organosilane of formula (I) has the formula RSiY₃, and preferably is selected from methyl trimethoxysilane, methyl triethoxysilane, ethyl trimethoxysilane, ethyl triethoxysilane, phenyl trimethoxysilane, phenyl triethoxysilane and mixtures thereof. It is also preferred that the tetrafunctional silane is selected from tetramethoxysilane and tetraethoxysilane.

In another embodiment, particularly useful etch differentiating layer compositions include one or more B-staged organic polysilica resins having the formula 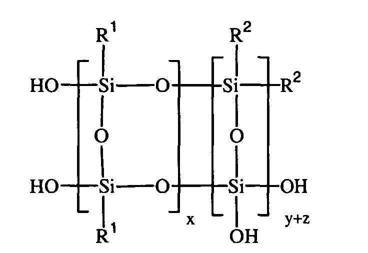 wherein each R¹ and R² are independently selected from hydroxyl, hydrogen, (C₁-C₆)alkyl, (C₂-C₆)alkenyl, and (C₁-C₆)alkylidine; x = 0.3 to 0.7; and y+z = 0.3 to 0.7; wherein x and y+z = the mole fraction of the components. When x+y+z does not equal 1, then it is understood that one or more other monomer units are included in the resin. Such other monomer units may be any which can co-condense with the monomer units of the above formula, and preferably are one or more of the above described silanes. It is preferred that x+y+z = 1. It is further preferred that R¹ and R² are independently selected from hydroxyl, hydrogen methyl, ethyl, vinyl, methylidine (-CH₂-) and ethylidine (-CH₂CH₂-). A particularly useful composition of this formula is where R¹ is methyl; R² is hydroxyl; x = 0.5 to 0.6; and y+z = 0.5 to 0.4. Such composition is prepared by the co-hydrolysis or co-condensation of methyl triethoxysilane and tetraethoxysilane. In general, resins having the above formula have a molecular weight of from 4000 to 100,000.

Suitable B-staged organic dielectric materials useful in the present invention include, but are not limited to, polyarylenes, polyarylene ethers and bezocyclobutenes disclosed in WO 00/31183 (Bruza et al.), and polyimides disclosed in U.S. Patent Nos. 6,093,636 (Carter et al.) and 5,969,088 (Ezzell et al.), all of which are hereby incorporated by reference to the extent these teach the preparation and use of such organic dielectric materials. Other suitable B-staged organic dielectric materials include polycycloolefins, such as polynorbornene homopolymers and copolymers and polydicyclopentadiene homopolymers and copolymers.

It will be appreciated that a mixture of dielectric materials may be used, such as two or more organic, two or more inorganic or a mixture of one or more organic and one or more inorganic dielectric materials. Thus, mixtures of alkyl/aryl silsesquioxanes, hydrido/alkyl silsesquioxanes, two or more polyarylene ethers, two or more polyimides, and the like may be used. Particularly suitable mixtures of dielectric materials include inorganic-organic hybrids, such as alkoxysilane/organic dielectric materials disclosed in European Patent Application EP 997 497 (Ioka et al.), hereby incorporated by reference to the extent this patent application discloses the preparation of such hybrid materials.

The porogens useful in the present invention are any which may be removed providing pores in the dielectric material chosen and reduce the dielectric constant of such material, particularly those dielectric materials having low dielectric constants ("k"). A low-k dielectric material is any material having a dielectric constant less than 4.

The removable porogens useful in the present invention are not substantially removed under the processing conditions used to cure the B-staged dielectric material or pattern the dielectric material. The present porogens are removed under conditions which do not substantially degrade or otherwise adversely affect the dielectric material.

A wide variety of removable porogens may be used in the present invention. Exemplary removable porogens may be polymers such as polymeric particles, or may be monomers or polymers that are co-polymerized with a dielectric monomer to form a block copolymer having a labile (removable) component. In an alternative embodiment, the porogen may be pre-polymerized with the dielectric monomer to form the B-staged dielectric material which may be monomeric, oligomeric or polymeric. Such pre-polymerized B-staged material is then cured to form a dielectric layer.

In an embodiment, the removable porogen is substantially non-aggregated or non-agglomerated in the B-staged dielectric material. Such non-aggregation or non-agglomeration reduces or avoids the problem of killer pore or channel formation in the dielectric matrix. It is preferred that the removable porogen is a porogen particle or is co-polymerized with the dielectric monomer, and more preferably a porogen particle. It is further preferred that the porogen particle is substantially compatible with the B-staged dielectric matrix material. By "substantially compatible" is meant that a composition of B-staged dielectric material and porogen is slightly cloudy or slightly opaque. Preferably, "substantially compatible" means at least one of a solution of B-staged dielectric material and porogen, a film or layer including a composition of B-staged dielectric material and porogen, a composition including a dielectric matrix material having porogen dispersed therein, and the resulting porous dielectric material after removal of the porogen is slightly cloudy or slightly opaque. To be compatible, the porogen must be soluble or miscible in the B-staged dielectric material, in the solvent used to dissolve the B-staged dielectric material or both. Suitable compatibilized porogens are those disclosed in U.S. Patent Nos. 6,420,441 (Allen et al.) and 6,271,273 (You et al.). Other suitable removable particles are those disclosed in U.S. Patent No. 5,700,844.

In one embodiment, the porogens comprises cross-linked polymeric particles. Typically, the amount of cross-linking agent is at least 1% by weight, based on the weight of the porogen. Up to and including 100% cross-linking agent, based on the weight of the porogen, may be effectively used in the particles of the present invention. It is preferred that the amount of cross-linker is from 1% to 80%, and more preferably from 1% to 60%. Any of a wide variety of cross-linking agents may be used. It will be appreciated by those skilled in the art that more than one cross-linking agent may be used to prepare such polymeric particles

Polymeric particle porogens typically have a molecular weight in the range of 10,000 to 1,000,000, more typically 10,000 to 500,000, and still more typically 10,000 to 100,000. Such polymeric particle porogens typically have a mean particle size of up to 1000 nm, such as from 0.5 to 250 nm. Other suitable mean particle sizes are from 1 to 100 nm and from 1 to 20 nm. Particularly suitable polymeric porogens have a mean particle size in the range of 1 to 10 nm. The particle size polydispersity of these materials is in the range of 1 to 20, preferably 1.001 to 15, and more preferably 1.001 to 10.

When the dielectric material comprises an organic polysilica material, it is preferred that the porogen includes at least one compound selected from silyl containing monomers or poly(alkylene oxide) monomers. More preferably, the porogen includes as polymerized units at least one compound selected from silyl containing monomers or poly(alkylene oxide) monomers and one or more cross-linking agents. Suitable cross-linked polymeric porogens for organic polysilica materials are disclosed in U.S. Patent No. 6,271,273 (You et al.).

Suitable block copolymers having labile components useful as removable porogens are those disclosed in U.S. Patent Nos. 5,776,990 and 6,093,636. Such block copolymers may be prepared, for example, by using as pore forming material highly branched aliphatic esters that have functional groups that are further functionalized with appropriate reactive groups such that the functionalized aliphatic esters are incorporated into, i.e. copolymerized with, the vitrifying polymer matrix. Such block copolymers are suitable for forming porous organic dielectric materials, such as benzocyclobutenes, poly(aryl esters), poly(ether ketones), polycarbonates, polynorbornenes, poly(arylene ethers), polyaromatic hydrocarbons, such as polynaphthalene, polyquinoxalines, poly(perfluorinated hydrocarbons) such as poly(tetrafluoroethylene), polyimides, polybenzoxazoles and polycycloolefins.

To be useful in forming porous dielectric materials, the porogens of the present invention must be at least partially removable under conditions which do not adversely affect the dielectric material, preferably substantially removable, and more preferably completely removable. By "removable" is meant that the porogen depolymerizes or otherwise breaks down into volatile components which are then removed from, or migrate out of, the dielectric material yielding pores. Any procedures or conditions which at least partially remove the porogen without adversely affecting the dielectric matrix material may be used. It is preferred that the porogen is substantially removed. Typical methods of removal include, but are not limited to: exposure to heat, pressure, vacuum or radiation such as, but not limited to, actinic, IR, microwave, UV, x-ray, gamma ray, alpha particles, neutron beam or electron beam. It will be appreciated that more than one method of removing the porogen or polymer may be used, such as a combination of heat and actinic radiation. In one embodiment, the dielectric material is exposed to heat and actinic acid to remove the porogen. The use of heat in combination with actinic radiation may reduce the temperature needed to remove the porogen. In one embodiment, the actinic radiation is UV light. An exemplary UV light source is a pulsed broadband UV light source such as those available from Xenon Corp., Woburn, Massachusetts. It will also be appreciated by those skilled in the art that other methods of porogen removal, such as by atom abstraction, may be employed.

The porogens of the present invention can be thermally removed under vacuum, nitrogen, argon, mixtures of nitrogen and hydrogen, such as forming gas, or other inert or reducing atmosphere. The porogens of the present invention may be removed at any temperature that is higher than the thermal curing temperature and lower than the thermal decomposition temperature of the dielectric material. Typically, the porogens of the present invention may be removed at temperatures in the range of 150° to 450° C and more typically in the range of 225° to 400° C. Typically, the porogens of the present invention are removed upon heating for a period of time in the range of 1 to 120 minutes. After removal from the dielectric material, 0 to 20% by weight of the porogen typically remains in the porous dielectric material.

In one embodiment, when a porogen of the present invention is removed by exposure to radiation, the porogen polymer is typically exposed under an inert atmosphere, such as nitrogen, to a radiation source, such as, but not limited to, visible or ultraviolet light. While not intending to be bound by theory, it is believed that porogen fragments form, such as by radical decomposition, and are removed from the matrix material under a flow of inert gas. The energy flux of the radiation must be sufficiently high such that porogen particles are at least partially removed.

The removable porogens are typically added to the B-staged dielectric materials of the present invention in an amount sufficient to provide the desired lowering of the dielectric constant. For example, the porogens may be added to the B-staged dielectric materials in any amount of from 1 to 90 wt%, based on the weight of the B-staged dielectric material, typically from 10 to 80 wt%, more typically from 15 to 60 wt%, and even more typically from 20 to 30 wt%.

When the removable porogens are not components of a block copolymer, they may be combined with the B-staged dielectric material by any methods known in the art. Typically, the B-staged material is first dissolved in a suitable high boiling solvent, such as methyl isobutyl ketone, diisobutyl ketone, 2-heptanone, γ-butyrolactone, γ-caprolactone, ethyl lactate propyleneglycol monomethyl ether acetate, propyleneglycol monomethyl ether, diphenyl ether, anisole, n-amyl acetate, n-butyl acetate, cyclohexanone, N-methyl-2-pyrrolidone, N,N'-dimethylpropyleneurea, mesitylene, xylenes, or mixtures thereof to form a solution. The porogens are then dispersed or dissolved within the solution. The resulting composition (e.g. dispersion, suspension or solution) is then deposited on a substrate by methods known in the art, such as spin coating, spray coating or doctor blading, to form a layer.

Suitable substrates upon which a dielectric layer may be disposed according to the present invention include, but are not limited to: silicon, silicon on insulator, silicon germanium, silicon dioxide, glass, silicon nitride, ceramics, aluminum, copper, gallium arsenide, plastics, such as polycarbonate, circuit boards, such as FR-4 and polyimide, and hybrid circuit substrates, such as aluminum nitride-alumina. Such substrates may further include thin films deposited thereon, such films including, but not limited to, metal nitrides, metal carbides, metal silicides, metal oxides, and mixtures thereof. In a multilayer integrated circuit device, an underlying layer of insulated, planarized circuit lines can also function as a substrate.

After being deposited on a substrate, the B-staged dielectric material is then at least partially cured, and preferably substantially cured, to form a rigid, cross-linked dielectric material without substantially removing the porogen. Such cured dielectric material is typically a coating or film. The curing of the dielectric material may be by any means known in the art including, but not limited to, heating to induce condensation or e-beam irradiation to facilitate free radical coupling of the oligomer or monomer units. Typically, the B-staged material is cured by heating at an elevated temperature, e.g. either directly or in a step-wise manner, e.g. 200° C for 2 hours and then ramped up to 300° C at a rate of 5° C per minute and held at this temperature for 2 hours. Such curing conditions are known to those skilled in the art and are dependent upon the particular B-staged dielectric material chosen.

The present invention provides a method of manufacturing an electronic device, particularly an integrated circuit, including the steps of: a) disposing on a substrate a layer of a first dielectric material including a first porogen; b) disposing a layer of a second dielectric material on the first dielectric material layer, wherein the second dielectric material includes a second porogen.

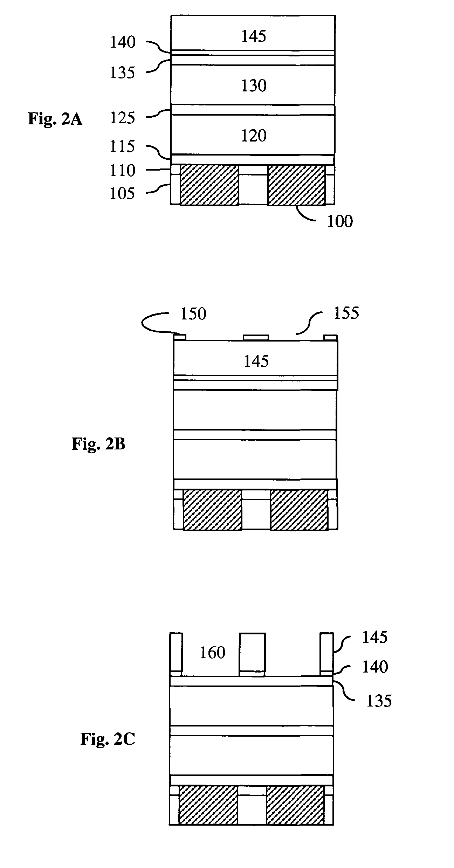

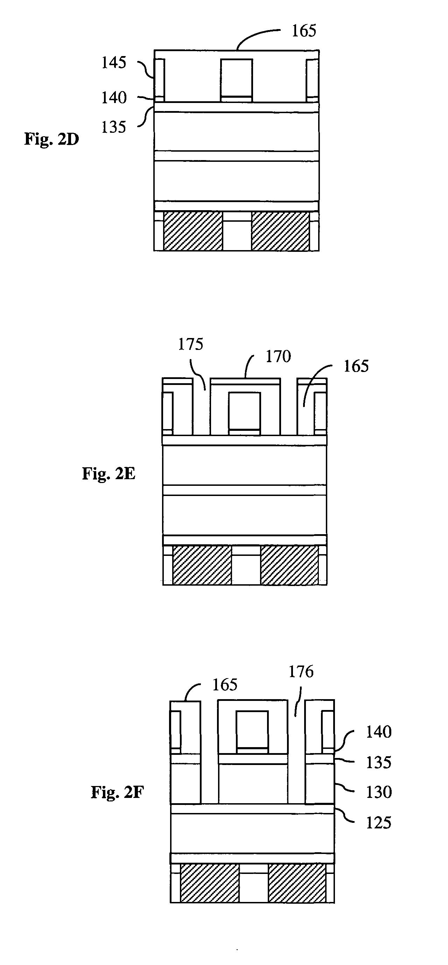

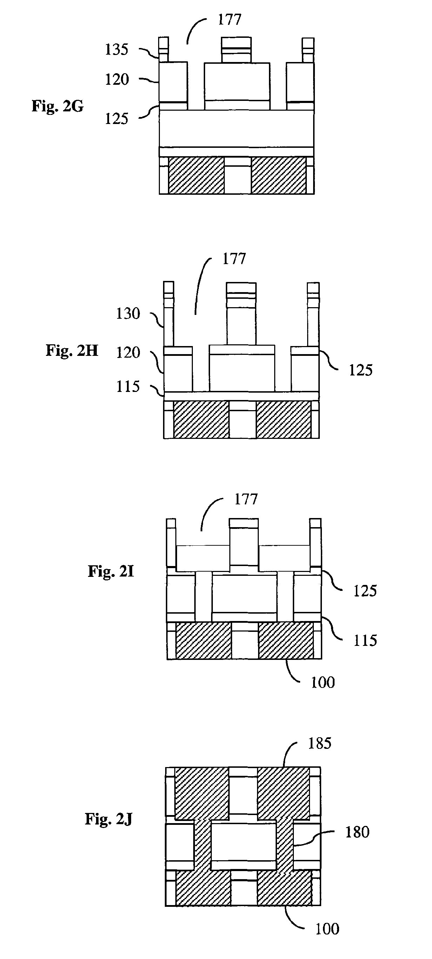

Figs. 2A-2J illustrate a method of manufacturing an integrated circuit having a multilayer porous dielectric stack. Referring to Fig. 2A, a structure is shown having a bottom dielectric layer 105 having metal studs **100** and an etch stop **110** which functions as a copper diffusion barrier, a hardmask layer **115** which also functions as a copper diffusion barrier, a first pre-porous organic polysilica dielectric layer **120** including a first porogen, an etch stop layer **125** including a third porogen, a second pre-porous dielectric layer **130** including a second porogen, such as a pre-porous organic polysilica dielectric layer, a spin-on pre-porous etch stop layer **135** including a porogen, a hardmask layer **140** and a first photoresist layer **145** of a bi-layer resist. To the top of the first photoresist layer **145** is added a second silicon-containing photoresist layer **150** and the second photoresist is imaged and developed to provide the desired aperture pattern **155,** see Fig. 2B. The aperture pattern is transferred through the first photoresist layer **145** and into the hardmask layer **140**, stopping at etch stop layer **135** and resulting in aperture pattern **160,** see Fig. 2C. As shown in Fig. 2D, and antireflecting planarizing layer **165** is spun on, filling the aperture pattern. Next, a silicon-containing photoresist **170** is spun on the top of the antireflective layer **165,** imaged and developed to provide the via pattern **175** in Fig. 2E. The via pattern is then transferred from antireflective layer **165** through pre-porous etch stop layer **135**, second pre-porous dielectric layer **130,** and stopping at pre-porous etch stop layer **125,** and the silicon resist is removed resulting in the structure shown in Fig. 2F. Next, an ash step is performed to remove the antireflective planarizing layer and the pre-porous etch stops **135** and **125** are then etched as shown in Fig. 2G. Both the first pre-porous dielectric layer **120** and the second pre-porous dielectric layer **130** are etched, stopping at pre-porous etch stop layer **115** to provide the via and trench structure **177,** shown in Fig. 2H. Next, etch stops **115** and **125** and any copper diffusion barrier are etched as shown in Fig. 2I, connecting the via and trench structure **177** with metal stud **100.** A metal is then deposited to fill the aperture providing trench **185** connecting to metal stud **100** by way of via **180**, as shown in Fig. 2J. When the metal is copper, a diffusion barrier is typically deposited in the aperture prior to copper deposition. Any overplating of metal is typically removed by planarization.

In one embodiment, seed layers may be applied to the dielectric material as the first metal layer or applied to a previously deposited barrier layer. Suitable seed layers include copper or copper alloys. When a seed layer is used without a barrier layer, it is preferred that the seed layer is not copper. Such seed layers may also be deposited by chemical vapor deposition or physical vapor deposition and are thin as compared to metallization layers. Alternatively, seed layers may be applied electrolessly. Thus, seed layers include catalysts for electroless plating.

Following such barrier and/or seed layer deposition, the aperture may be metallized or filled, such as with copper or copper alloy. Such metallization may be by any means, but is preferably at least partially electrolytic, and more preferably electrolytic. Methods of metallizing such apertures are well known to those skilled in the art. For example, ULTRAFILL™ 2001 EP copper plating chemistries, available from Shipley Company (Marlborough, Massachusetts), may be used for electrolytic copper metallization of apertures.

In the alternative, the apertures may be metallized or filled electrolessly without the need for barrier or seed layers. If apertures are electrolessly metallized with copper, a barrier layer is preferred.

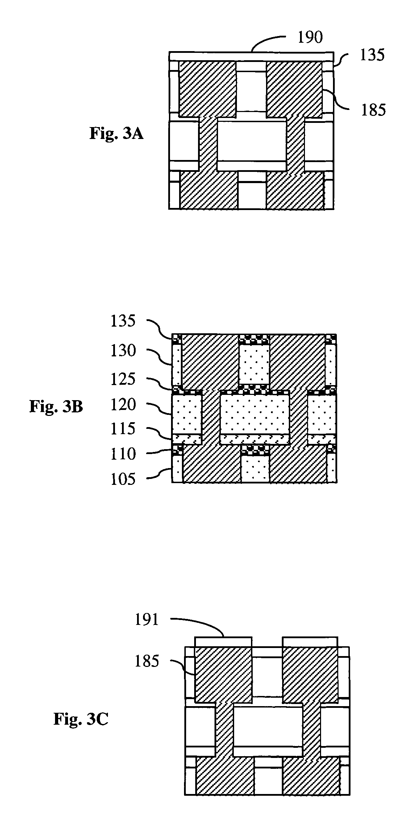

A copper diffusion barrier **190** may be deposited over trench **185** and etch stop layer **135,** as shown in Fig. 3A. Such copper diffusion barrier **190** may be any suitable diffusion barrier and may also function as an etch differentiating layer. Alternatively, the structure may be subjected to conditions, such as heating, irradiation, oxidizing atmospheres or any combination thereof, to convert all the pre-porous layers to porous layers. Such a structure is shown in Fig. 3B having porous bottom dielectric layer **105**, porous etch stop layer **110,** porous hardmask layer **115,** first porous dielectric layer **120,** porous etch stop layer **125,** second porous dielectric layer **130** and porous etch stop layer **135.** In an alternative embodiment, a diffusion barrier may be added to the top of the structure shown in Fig. 3B.

Preferably, a copper diffusion barrier is selectively deposited on the surface of the copper. Such a structure is shown in Fig. 3C where copper diffusion barrier **191** is deposited on the top of copper trench **185.** Such selective deposition may be performed by a variety of means, such as immersion plating, or electroless plating. Any conducting material that inhibits or reduces copper migration into the adjoining dielectric layers may be used. Suitable diffusion barrier materials include, but are not limited to, nickel, chromium, cobalt, cobalt-tungsten-phosphide, silver, gold, palladium, platinum, ruthenium and the like. In immersion or displacement plating, metal deposition occurs when the dissolved metal ions in a plating bath are displaced by a more active (less noble) metal that is contacted with the plating bath. Immersion plating is particularly suitable it will not deposit metal on the surrounding dielectric, only on the exposed copper surfaces. In an alternate embodiment, a copper colloid composition, such as that disclosed in European Patent Application No. 0 707 093 A1. Other electroless metal plating baths are also suitable.

Thus, the present invention further provides a method of manufacturing an electronic device including the steps of: a) disposing on a substrate a layer of a dielectric material; b) patterning the dielectric material layer to provide apertures; c) depositing a barrier layer in the apertures; d) depositing copper in the apertures to fill the apertures; e) planarizing the copper; and f) selectively depositing a barrier layer on the surface of the copper. Also provided herein is a structure including a substrate; a dielectric layer disposed on the surface of the substrate, the dielectric layer comprising apertures extending from a top surface of the dielectric layer downardly into the dielectric layer; copper disposed in the apertures and having a top surface substantially even with the top surface of the dielectric layer; and a barrier layer selectively disposed on the top surface of the copper.

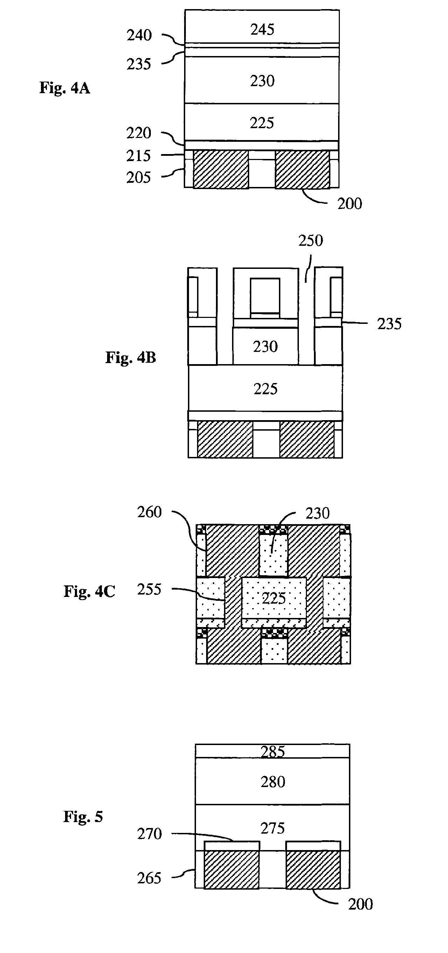

In an alternate embodiment, an etch differentiating layer is not disposed between the first and second dielectric layers. Suitable etch differential between the layers is achieved by the use of certain porogens in each of the dielectric layers. This is described in Figs. 4A-4C. Referring to Fig. 4A, a structure is shown having pre-porous bottom dielectric layer **205** including a polymeric porogen and having pre-porous etch stop **215** and metal studs **200.** Pre-porous hardmask **220** including a polymeric porogen is disposed on the surface of pre-porous etch stop **215** and metal studs **200.** First pre-porous dielectric layer **225** including a polymeric porogen is disposed on hardmask **220** which may also function as a copper diffusion barrier, and second pre-porous dielectric layer **230** including a polymeric porogen is disposed directly on first pre-porous dielectric layer **225.** On the surface of dielectric layer **230** are disposed pre-porous etch stop or cap layer **235** including a polymeric porogen, hardmask **240** which may also function as a copper diffusion barrier and photoresist **245.** The photoresist is then imaged, the hardmask etched, an antireflective planarizing layer is next applied, followed by a silicon-containing photoresist. This photoresist is imaged, the via pattern **250** transferred into etch stop 235 and second dielectric layer **230**, as shown in Fig. 4B. The antireflective layer is removed and trenches are etched into second dielectric layer **230** and vias are etched into first dielectric layer **225.** A barrier layer is next deposited, trenches **260** and vias **255** are filled with copper and any overplating removed by planarization such as chemical mechanical planarization. The structure is then subjected to conditions which convert all the pre-porous layers to porous layers, resulting in the structure shown in Fig. 4C.

In another embodiment, Fig. 5 illustrates a structure having bottom pre-porous dielectric layer **265** contiguous to metal studs **200**. On top of metal studs **200** is a selectively deposited barrier layer **270.** First pre-porous dielectric layer **275** is disposed on bottom dielectric layer **265** and barrier layer **270.** Second pre-porous dielectric layer **280** is disposed directly on first dielectric layer **275**.

In another embodiment, a sacrificial material may be used as a dielectric layer. Upon removal, the sacrificial material forms an air gap. Such a structure is particularly useful in a dual damascene process, where an air gap is typically formed in a trench layer. In such a structure, a sacrificial material is disposed on a first dielectric layer. Preferably, the first dielectric layer includes a porogen. A third layer is then disposed on the top of the sacrificial material layer. Accordingly, the present invention provides a structure including a first layer of a dielectric material comprising a porogen, a second layer including a sacrificial material, and a third layer on the second layer, wherein the third layer is inorganic. Such third layer must have sufficient porosity to allow for removal of the sacrificial material and the porogen through the third layer. In one embodiment, such porosity in the third layer is achieved by the use of a porogen, and, thus, the third layer may include one or more porogens. Preferably, the third layer is also an organic polysilica layer. In another embodiment, the dielectric material includes an organic polysilica material.

A wide variety of material may be used as the sacrificial material. Suitable sacrificial material includes, without limitation, polynorbornene polymers, benzocyclobutene polymers, polysulfone polymers, poyl(meth)acrylate polymers, and the like. Preferably, the sacrificial material is a cross-linked polymer. Exemplary cross-linked polymers include, without limitation, polymers containing as polymerized units one or more monomers of (meth)acrylic acid, (meth)acrylamides, alkyl (meth)acrylates, alkenyl (meth)acrylates, aromatic (meth)acrylates, vinyl aromatic monomers, nitrogen-containing compounds and their thio-analogs, substituted ethylene monomers, cyclic olefins, substituted cyclic olefins, and the like, and one or more cross-linking agents.

Particularly suitable sacrificial material polymers are those including as polymerized units one or more (meth)acrylate monomers, (meth)acrylamide monomers or both. Such polymers may include one or more other monomers as polymerized units, such as those described above. (Meth)acrylate monomers include alkyl (meth)acrylates, alkenyl (meth)acrylates, and aromatic (meth)acrylates. (Meth)acrylamide monomers include (meth)acrylamide and alkyl (meth)acrylamides. Typically, the alkyl (meth)acrylates useful in the present invention are (C₁-C₂₄)alkyl (meth)acrylates.

A wide variety of cross-linking agents may be used in the present invention. Suitable cross-linkers include, but are not limited to, di-, tri-, tetra-, or higher multi-functional ethylenically or acetylenically unsaturated monomers, and more preferably multifunctional (meth)acrylate monomers. Any amount of cross-linker is suitable for use in the present sacrificial material polymers. Typically, the present polymers contain at least 1% by weight of cross-linker, based on the weight of the polymer. Up to and including 100% cross-linking agent, based on the weight of the polymer, may be effectively used in the polymers of the present invention. It is preferred that the amount of cross-linker is from 5% to 100%, and more preferably from 10% to 90%. Other suitable amounts of cross-linker are from 5 to 75%, from 10 to 75% and from 10 to 50%. In one embodiment, the cross-linked polymer may include only cross-linking monomers as the polymerized units, or may include one or more other monomers. For example, a cross-linked polymer including trimethylolpropane triacrylate and trimethylolpropane trimethacrylate is particularly useful.

When a sacrificial material is used as a dielectric material, such sacrificial material is disposed on a substrate to form a sacrificial material layer. Such layer may be formed by disposing a composition containing a cross-linked polymer on the substrate. Alternatively, such sacrificial material layer may be formed by disposing a composition containing one or more cross-linking agents on the substrate, followed by curing the one or more cross-linking agents to form a cross-linked polymer on the substrate. Optionally, such composition containing one or more cross-linking agents may also contain one or more monomers, one or more uncross-linked polymers, one or more cross-linked polymers, or a mixture of any of the foregoing.

The sacrificial material layer may be disposed on the substrate as a melt or as a composition in a solvent. Alternatively, the sacrificial material may be a dry film which can be applied to the substrate by conventional means such as vacuum lamination. In a further alternative, the sacrificial material may be deposited by chemical vapor deposition. A wide variety of solvents may be used. The choice of solvent will depend on the particular application and the composition of the polymer. Suitable solvents include, but are not limited to: ketones; lactones; esters; ethers; N-methyl-2-pyrrolidone; N,N'-dimethylpropyleneurea; aromatic solvents; alcohols; hydrocarbons; acids or mixtures thereof. Any suitable means may be used to dispose the sacrificial material melt or composition on the substrate, such as spin coating, dipping, roller coating, curtain coating, and the like.

When a sacrificial material composition is cured on a substrate to form a sacrificial material layer, such curing may be by any method that increases the molecular weight of one or more components in the composition. Typically, such method is polymerization. Such polymerization may be by any method such as Diels-Alder, anionic, cationic and, preferably, free-radical polymerization. Polymerization may be initiated thermally, photochemically, or by a combination of the two. Any suitable polymerization catalyst may then be added to the sacrificial material composition, such as thermal acid generators, thermal base generators, photoacid generators, photobase generators, free-radical initiators, and the like.

The sacrificial material must be removable from the substrate. A wide variety of conditions may be used to effect such removal, including, without limitation, exposure to heat, pressure, vacuum or radiation such as, but not limited to, actinic, IR, microwave, UV, x-ray, gamma ray, alpha particles, neutron beam, and electron beam, dissolution, chemical etching, plasma etching and the like. It will be appreciated that more than one method of removing the porogen or polymer may be used, such as a combination of heat and actinic radiation. Thermal decomposition of the sacrificial material is preferred.

When using the present invention in a damascene process, it is important to provide active sites on the porogen and sacrificial material to provide for the deposition of a barrier layer on such materials. Such sites should be uniformly distributed on the surface of such materials, including in any apertures formed in layers of such materials. While this is less critical for physical vapor deposition methods, it is critical for chemical layer deposition and especially for atomic layer chemical vapor deposition. In atomic layer deposition the barrier layer is deposited by first exposing the etched surface to a reactive gas in a vacuum chamber allowing the deposition of a single layer of metal atoms by reaction of the metal with functional groups on the polymer surface. Exemplary precursors for such deposition include, but are not limited to, reactive metal halides such as titanium tetrachloride, TaCl₅, and TiBr₄, reactive metal alkoxides, metal amine complexes, metal carbonyl complexes such as W(CO)₆, and the like. In a subsequent step, excess metal precursor is removed from the chamber and then a different gas such as ammonia is introduced to the surface to react with the TiCl₃ and TiCl₂ that reside on the surface. The reaction results in the formation of Ti-N bonds and then the excess ammonia is removed and the process repeated until a sufficiently thick barrier is created to prevent copper diffusion. Other amines can be also used, such as methylamine. Carbon precursors can also be used in combination with the amines or alone to create titanium carbonitride or a titanium carbide layer instead of the titanium nitride layer formed by the reaction with ammonia.

One method of creating sufficient active sites in the sacrificial material or porogens is to incorporate reactive functional groups into the sacrificial material, such as carboxylate, amine, imine, oxime, hydroxy, aldehyde, disulfide, or thiol groups or any combination thereof, that allow the reactive metal species to react uniformly with the sacrificial material after etch and thereby minimizing the thickness required for the barrier layer. An alternate embodiment to creating a uniform barrier uses a sacrificial polymer including a silicon-containing monomer as polymerized units that after etch provides a sufficient number of surface silanol groups to provide good surface coverage for the reactive metal species. Such alternate method is preferred as the silicon-oxygen-metal bonds are extremely stable and will provide good adhesion of the barrier layer to the sacrificial material.

Accordingly, the present invention provides a method of manufacturing an electronic device including the steps of: a) disposing on a substrate a layer of a first dielectric material including a first porogen; b) disposing a layer of a second dielectric material on the first dielectric material layer, the second dielectric material including a second porogen or a sacrificial material; c) patterning the layers of both the first and second dielectric materials to provide apertures; d) vapor depositing a barrier layer on the surface of the first and second dielectric materials within the apertures; and e) depositing a metal into the apertures; wherein the first porogen, the second porogen and the sacrificial material have active sites suitable for providing a barrier layer.

In another embodiment, barrier layer deposition may be alternated with another intermetallic layer, such as carbides, silicides, borides, carbonitrides, nitrides and the like. Such alternating layers of barrier materials and intermetallic layers are well known in the art.

## Claims

1. A device comprising a first dielectric layer comprising a first removable material, and a second dielectric layer comprising a second removable material.

2. The device of claim 1 further comprising an etch differentiating layer disposed between the first dielectric layer and the second dielectric layer.

3. The device of claim 2 wherein the etch differentiating layer comprises a third removable material.

4. The device of any one of claims 1 to 3 wherein at least one of the first removable material and second removable material comprises cross-linked polymeric particles.

5. The device of any one of claims 1 to 4 further comprising a third layer on the second layer, wherein the third layer is inorganic.

6. The device of claim 5 wherein the third layer has sufficient porosity to allow for removal of the first removable material and the second removable material through the third layer.

7. A method of manufacturing an electronic device comprising the steps of: a) providing the device of any one of claims 1 to 6; and b) subjecting the electronic device to conditions which at least partially remove the second removable material.

8. A method of manufacturing an electronic device comprising the steps of: a) providing the device of any one of claims 1 to 6; b) patterning the layers of both the first and second dielectric materials to provide apertures; c) vapor depositing a barrier layer on the surface of the first and second dielectric materials within the apertures; and d) depositing a metal into the apertures; wherein the first removable material and the second removable material have active sites suitable for providing a barrier layer.

9. A method of manufacturing an electronic device comprising the steps of: a) disposing on a substrate a layer of a dielectric material; b) patterning the dielectric material layer to provide apertures; c) depositing a barrier layer in the apertures; d) depositing copper in the apertures to fill the apertures; e) planarizing the copper; and f) selectively depositing a barrier layer on the surface of the copper.

10. A structure comprising a substrate; a dielectric layer disposed on the surface of the substrate, the dielectric layer comprising apertures extending from a top surface of the dielectric layer downwardly into the dielectric layer; copper disposed in the apertures and having a top surface substantially planar with the top surface of the dielectric layer; and a barrier layer selectively disposed on the top surface of the copper.
